# EUROPEAN PATENT APPLICATION

(11) **EP 4 250 547 A1**
(43) Date of publication of application: **27.09.2023**
(21) Application number: 20964724.7
(22) Date of filing: 11.12.2020
(51) Int. Cl.: H02M 3/158

(54) **SWITCH MODE POWER SUPPLY, CHIP, AND DEVICE**

(71) Applicant: Huawei Technologies Co., Ltd., Shenzhen, Guangdong 518129 (CN)
(72) Inventor: CHEN, Yue, Shenzhen, Guangdong 518129 (CN); ZHANG, Wenlin, Shenzhen, Guangdong 518129 (CN); WANG, Jiake, Shenzhen, Guangdong 518129 (CN)
(74) Representative: Gill Jennings & Every LLP
(86) International application number: PCT/CN2020/135637
(87) International publication number: WO 2022/120788

(57) **Abstract**

A switching power supply is disclosed, used for a direct current voltage conversion device. The switching power supply includes: a first power transistor (M1) and a second power transistor (M2) serially connected between a first voltage terminal (VDD1) and a ground terminal (GND), a first drive circuit (1) and a second drive circuit (2) respectively driving the first power transistor (M1) and the second power transistor (M2), a logic processing circuit (3), and a dead zone control circuit (4). The logic processing circuit (3) is configured to perform logic processing based on pulse width modulation signals (PWM1, PWM2) received by the foregoing two drive circuits (1, 2) and generate a first enable signal (S1). The dead zone control circuit (4) is configured to receive the first enable signal (S1) and a pre-turn-on voltage, and when the first enable signal (S1) is valid and the first power transistor (M1) is switched off, output the pre-turn-on voltage to turn on the second power transistor (M2). Therefore, the control circuit can enable the first enable signal (S1) to be valid before a dead zone starts, and when the first power transistor (M1) is switched off, quickly turn on the second power transistor (M2) via a pre-turn-on voltage, to end a dead zone between the first power transistor (M1) and the second power transistor (M2).

## Description

### TECHNICAL FIELD

This application relates to the field of electronic technologies, and in particular, to a switching power supply, a chip, and a device.

### BACKGROUND

The switching power supply is a power supply that maintains a stable output voltage by controlling a time ratio of turn-on and turn-off of a power transistor (usually including an upper transistor connected to a voltage terminal and a lower transistor connected to a ground terminal). With continuous increase of working frequency of the switching power supply, a loss of the switching power supply accordingly increases continuously. The loss of the switching power supply usually includes a turn-on loss and a switching loss. The turn-on loss includes a loss introduced by resistors of a device like a power transistor and an inductor. The switching loss includes a loss introduced by a change of currents and voltages of a device like a power transistor and a capacitor in a switching process. A dead zone loss is one of main losses in the turn-on loss. A longer dead time indicates a greater loss. Reducing the dead time is an important means to reduce the dead zone loss and improve efficiency of the switching power supply. The dead time refers to a period of time within which the upper and lower transistors are switched off at the same time during alternate turn-on and turn-off to avoid being turned on at the same time during the turn-on and turn-off and causing punch-through damage to the switching power supply.

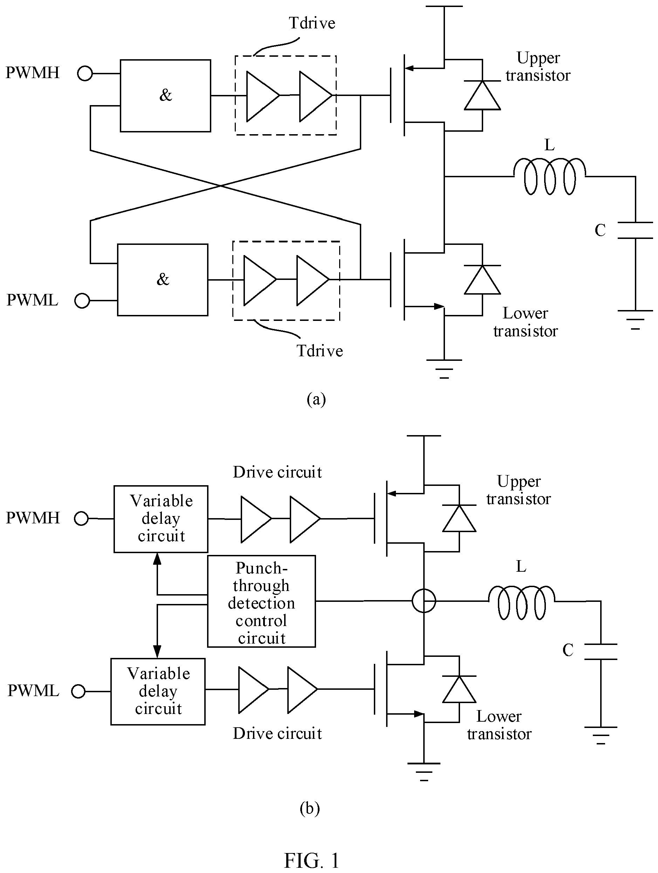

In the conventional technologies, the dead zone is usually realized by using the following several methods. According to a first method, in a switching power supply as shown in (a) in FIG. 1, a dead zone is realized by logical interlocking. The switching power supply includes an upper transistor, a lower transistor, and two drive circuits that are respectively configured to drive the upper transistor and the lower transistor. Each drive circuit includes an AND gate & and a drive delayer Tdrive. An AND gate & in a drive circuit corresponding to any one power transistor of the upper transistor and the lower transistor may be configured to detect a gate voltage of another power transistor. Therefore, the drive circuit of the upper transistor may be turned on when it is detected that the gate voltage is stable after the lower transistor is switched off, and the drive circuit of the lower transistor may be turned on when it is detected that the gate voltage is stable after the upper transistor is switched off. According to a second method, in a switching power supply as shown in (b) in FIG. 1, a dead zone is realized by dynamically detecting and adjusting the dead zone. The switching power supply includes an upper transistor, a lower transistor, and two drive circuits that are respectively configured to drive the upper transistor and the lower transistor. Each drive circuit is serially connected to a variable delay circuit. The variable delay circuit is connected to coupling points of the upper transistor and the lower transistor through a punch-through detection control circuit. A specific principle is as follows. In an initial phase, a relatively large dead time is set through two variable delay circuits, and then the dead time is gradually reduced. When the punch-through detection control circuit detects that the upper transistor and the lower transistor punch through, the dead time is gradually increased by two variable delay circuits. To be specific, the dead time is dynamically adjusted in a dead zone feedback manner. In FIG. 1, L is an inductor, C is a capacitor, and PWMH and PWML respectively represent pulse width modulation (pulse width modulation) signals corresponding to an upper transistor and a lower transistor.

In the foregoing first method, a particular driving delay is required for the drive delayer Tdrive to drive the transistor to be turned on, and the driving delay becomes a bottleneck for reducing the dead time. Therefore, only a nanosecond-level dead zone can be realized, and therefore the first method is hardly appropriate for a high-frequency switching power supply. In the foregoing second method, adjustment of the dead zone is a hysteresis adjustment. That is, adjustment of the dead zone in a next periodicity is performed after the punch-through is detected in the previous periodicity, so that the switching power supply works at an edge of the punch-through and non-punch-through. Therefore, a great punch-through risk exists, and therefore the second method is hardly appropriate for the high-frequency switching power supply as well.

### SUMMARY

This application provides a switching power supply, a chip, and a device, to reduce a dead time, so that the switching power supply is applicable to a high-frequency switching power supply.

To achieve the foregoing objectives, the following technical solutions are used in embodiments of this application.

According to a first aspect, a switching power supply is provided. The switching power supply includes: a first power transistor and a second power transistor, where the first power transistor and the second power transistor are serially coupled between a first voltage terminal and a ground terminal, and the first power transistor and the second power transistor are coupled to a first node (for example, the first power transistor is coupled between the first voltage terminal and the first node, and the second power transistor is coupled between the first node and the ground terminal; alternatively, the second power transistor is coupled between the first voltage terminal and the first node, and the first power transistor is coupled between the first node and the ground terminal); a first drive circuit, configured to drive the first power transistor based on a first pulse width modulation signal, where for example, when the first power transistor is an NMOS transistor, the first drive circuit turns on the first power transistor when the first pulse width modulation signal is at a high level, and turns off the first power transistor when the first pulse width modulation signal is at a low level; a second drive circuit, configured to drive the second power transistor based on a second pulse width modulation signal, for example, when the second power transistor is an NMOS transistor, the second drive circuit turns on the second power transistor when the second pulse width modulation signal is at a high level, and turns off the second power transistor when the second pulse width modulation signal is at a low level; a logic processing circuit, configured to output a first enable signal based on the first pulse width modulation signal and the second pulse width modulation signal, for example, output a valid first enable signal based on the first pulse width modulation signal and the second pulse width modulation signal before a dead zone of the switching power supply starts; and a dead zone control circuit, configured to receive the first enable signal and a pre-turn-on voltage, and output a pre-turn-on voltage when the first enable signal is valid and the first power transistor is switched off, where the pre-turn-on voltage turns on the second power transistor.

In the foregoing technical solution, in a process in which the first drive circuit and the second drive circuit drive, through the first pulse width modulation signal and the second pulse width modulation signal respectively, the first power transistor and the second power transistor to perform voltage conversion, the logic processing circuit may output a valid first enable signal based on the first pulse width modulation signal and the second pulse width modulation signal before the dead zone of the switching power supply starts, so that the dead zone control circuit provides a pre-turn-on voltage under the valid first enable signal. In this way, the output pre-turn-on voltage when the first power transistor is switched off can quickly turn on the second power transistor, to end the dead zone, and implement dead zone control with zero dead time, so that the switching power supply can meet various requirements in high-frequency applications.

In a possible implementation of the first aspect, the second power transistor is an NMOS transistor. In this case, the first power transistor may be a PMOS transistor or an NMOS transistor. In the foregoing possible implementation, the second power transistor is an NMOS transistor. In this case, when the first power transistor is switched off, a gate voltage of the second power transistor is pulled up to the pre-turn-on voltage, a drain voltage of the second power transistor is a voltage of the first node, and the pre-turn-on voltage is greater than the voltage of the first node. In this way, the second power transistor is quickly turned on, to end the dead zone, and implement dead zone control with zero dead time.

In a possible implementation of the first aspect, the dead zone control circuit includes a first transistor and a second transistor. For example, both the first transistor and the second transistor are PMOS transistors. The first transistor and the second transistor are serially coupled between gates of a second voltage terminal and the second power transistor. A gate of the first transistor is configured to receive the first enable signal, and a gate of the second transistor is coupled to the first node. In the foregoing possible implementation, the first transistor may be turned on under a valid first enable signal, to pull up a source voltage of the second transistor to the pre-turn-on voltage. When the first power transistor is switched off so that the voltage of the first node is reduced, the second transistor is quickly turned on, and the gate voltage of the second power transistor is pulled up to the pre-turn-on voltage, so that the second power transistor is quickly turned on.

In a possible implementation of the first aspect, the switching power supply further includes a weak pull-down circuit, configured to maintain a gate state of the second power transistor when the second enable signal is valid. The second enable signal is an inversion signal of the first enable signal. In the foregoing possible implementation, the weak pull-down circuit can improve stability when the second power transistor is turned on, thereby improving stability of the switching power supply.

In a possible implementation of the first aspect, the weak pull-down circuit includes a resistor and a third transistor. The third transistor may be an NMOS transistor. The resistor is coupled between the gate of the second power transistor and an electrode of the third transistor. Another electrode of the third transistor is coupled to the ground terminal. A gate of the third transistor is configured to receive the second enable signal. In the foregoing possible implementation, when the gate of the third transistor receives a valid second enable signal (assuming valid at a high level), a gate voltage of the third transistor is pulled up, and the third transistor is turned on, so that the gate of the second power transistor is connected to the ground terminal, and impedance of the gate of the second power transistor is equal to a sum of on impedance of the resistor and on impedance of the third transistor. That is, the impedance of the gate of the second power transistor is relatively large, so that when a gate current of the second power transistor is relatively small, a relatively large voltage may be provided for the gate of the second power transistor.

In a possible implementation of the first aspect, the logic processing circuit includes a delayer and a D flip-flop. An input of the delayer is configured to receive the second pulse width modulation signal. An output of the delayer is coupled to a reset end of the D flip-flop. An input of the D flip-flop is set to a high level. A clock end of the D flip-flop is configured to receive the first pulse width modulation signal. An output of the D flip-flop is configured to output a first enable signal. Alternatively, the logic processing circuit includes a delayer, an AND gate, and three NOT gates. An input of a first NOT gate in the three NOT gates is configured to receive the first pulse width modulation signal. An output of the first NOT gate is coupled to an input of the AND gate. An input of the delayer is configured to receive the second pulse width modulation signal. An output of the delayer is coupled to another input of the AND gate through a second NOT gate in the three NOT gates. An output of the AND gate is coupled to an input of a third NOT gate in the three NOT gates. An output of the third NOT gate is configured to output the first enable signal. In the foregoing possible implementation, two possible logic processing circuits are provided, so that flexibility and diversity of designing the logic processing circuit can be improved.

In a possible implementation of the first aspect, the second drive circuit includes a NOT gate, a NOR gate, a first drive amplification circuit, and a second drive amplification circuit. An input of the NOT gate is coupled to a first input of the NOR gate and is configured to receive the second pulse width modulation signal. An output of the NOT gate is coupled to an input of a first drive amplification circuit. A second input of the NOR gate is configured to receive the second enable signal. An output of the NOR gate is coupled to an input of the second drive amplification circuit. Both an output of the first drive amplification circuit and an output of the second drive amplification circuit are coupled to a gate of the second power transistor. In the foregoing possible implementation, when the second enable signal is invalid, the second drive circuit is turned on, so that the second drive circuit may normally drive the second power transistor based on the second pulse width modulation signal. When the second enable signal is valid, the second drive circuit is switched off, so that the second drive circuit cannot be configured to drive the second power transistor, thereby avoiding impact of the second drive circuit on a gate state when the second power transistor is turned on.

In a possible implementation of the first aspect, the second power transistor is a PMOS transistor. In this case, the first power transistor may be an NMOS transistor. In the foregoing possible implementation, the second power transistor is a PMOS transistor. When the first power transistor is switched off, the gate voltage of the second power transistor is pulled down to the pre-turn-on voltage (that is, the ground terminal), the drain voltage of the second power transistor is the voltage of the first node, and the pre-turn-on voltage is less than the voltage of the first node. In this way, the second power transistor is quickly turned on, to end the dead zone, and implement dead zone control with zero dead time.

In a possible implementation of the first aspect, the dead zone control circuit includes a first transistor and a second transistor. For example, both the first transistor and the second transistor are NMOS transistors. The first transistor and the second transistor are serially coupled between gates of the ground terminal and the second power transistor. The gate of the first transistor is configured to receive the first enable signal. The gate of the second transistor is coupled to the first node. In the foregoing possible implementation, the first transistor may be turned on under a valid first enable signal, to pull down the source voltage of the second transistor. When the first power transistor is switched off so that the voltage of the first node is pulled up, the second transistor is quickly turned on, and the gate voltage of the second power transistor is pulled down, so that the second power transistor is quickly turned on.

In a possible implementation of the first aspect, the switching power supply further includes a weak pull-up circuit, configured to maintain a gate state of the second power transistor when the second enable signal is valid. The second enable signal is an inversion signal of the first enable signal. In the foregoing possible implementation, the weak pull-up circuit can improve stability when the second power transistor is turned on, thereby improving stability of the switching power supply.

In a possible implementation of the first aspect, the weak pull-up circuit includes a resistor and a third transistor. The third transistor may be a PMOS transistor. The resistor is coupled between a gate of the second power transistor and an electrode of the third transistor. Another electrode of the third transistor is coupled to the first voltage terminal. The gate of the third transistor is configured to receive the second enable signal. In the foregoing possible implementation, when the gate of the third transistor receives the valid second enable signal, the gate voltage of the third transistor is pulled down, and the third transistor is switched off, so that the gate of the second power transistor is connected to the first voltage terminal, and impedance of the gate of the second power transistor is equal to a sum of on impedance of the resistor and on impedance of the third transistor. That is, the impedance of the gate of the second power transistor is relatively large, so that when the gate current of the second power transistor is relatively small, a relatively large voltage may be provided for the gate of the second power transistor.

In a possible implementation of the first aspect, the logic processing circuit includes two NOT gates, a delayer, and a D flip-flop. An input of a first NOT gate in the two NOT gates is configured to receive the second pulse width modulation signal. An output of the first NOT gate is coupled to a reset end of the D flip-flop through the delayer. An input of the D flip-flop is at a high level. An input of a second NOT gate in the two NOT gates is configured to receive the first pulse width modulation signal. An output of the second NOT gate is coupled to a clock end of the D flip-flop. An output of the D flip-flop is configured to output the first enable signal. Alternatively, the logic processing circuit includes a delayer, an AND gate, and a NOT gate. An input of the AND gate is configured to receive a first pulse width modulation signal. An input of the delayer is configured to receive a second pulse width modulation signal. An output of the delayer is coupled to another input of the AND gate. An output of the AND gate is coupled to the input of the NOT gate. An output of the NOT gate is configured to output the first enable signal. In the foregoing possible implementation, two possible logic processing circuits are provided, so that flexibility and diversity of designing the logic processing circuit can be improved.

In a possible implementation of the first aspect, the second drive circuit includes a NOT gate, a NAND gate, a first drive amplification circuit, and a second drive amplification circuit. An input of the NOT gate is coupled to a first input of the NAND gate and is configured to receive the second pulse width modulation signal. An output of the NOT gate is coupled to an input of a first drive amplification circuit. A second input of the NAND gate is configured to receive a second enable signal. An output of the NAND gate is coupled to an input of a second drive amplification circuit. Both an output of the first drive amplification circuit and an output of the second drive amplification circuit are coupled to a gate of the second power transistor. In the foregoing possible implementation, when the second enable signal is invalid, the second drive circuit is turned on, so that the second drive circuit may normally drive the second power transistor based on the second pulse width modulation signal. When the second enable signal is valid, the second drive circuit is switched off, so that the second drive circuit cannot be configured to drive the second power transistor, thereby avoiding impact of the second drive circuit on a gate state when the second power transistor is turned on.

In a possible implementation of the first aspect, the switching power supply further includes a power output path. The power output path includes an inductor and a capacitor that are serially coupled between the first node and the ground terminal.

According to a second aspect, a switching power supply is provided. The switching power supply includes a first power transistor and a second power transistor, where the first power transistor and the second power transistor are serially coupled between a first voltage terminal and a ground terminal, and the first power transistor and the second power transistor are coupled to a first node (for example, the first power transistor is coupled between the first voltage terminal and the first node, and the second power transistor is coupled between the first node and the ground terminal; alternatively, the second power transistor is coupled between the first voltage terminal and the first node, and the first power transistor is coupled between the first node and the ground terminal); a first drive circuit, configured to drive the first power transistor based on the first pulse width modulation signal, where for example, when the first power transistor is an NMOS transistor, the first drive circuit turns on the first power transistor when the first pulse width modulation signal is at a high level, and turns off the first power transistor when the first pulse width modulation signal is at a low level; a second drive circuit, configured to drive the second power transistor based on the second pulse width modulation signal, where for example, when the second power transistor is an NMOS transistor, the second drive circuit turns on the second power transistor when the second pulse width modulation signal is at a high level, and turns off the second power transistor when the second pulse width modulation signal is at a low level; a logic processing circuit, including two inputs respectively configured to receive the first pulse width modulation signal and the second pulse width modulation signal and a first output configured to output a first enable signal; and a dead zone control circuit, including a first transistor and a second transistor that are serially coupled between gates of a second voltage terminal and the second power transistor or between gates of the ground terminal and the second power transistor, where a gate of the first transistor is configured to receive the first enable signal, and a gate of the second transistor is coupled to the first node.

In the foregoing technical solution, in a process in which the first drive circuit and the second drive circuit respectively drive, through the first pulse width modulation signal and the second pulse width modulation signal, the first power transistor and the second power transistor to perform voltage conversion, the logic processing circuit may output, through the first output, a valid first enable signal based on the first pulse width modulation signal and the second pulse width modulation signal that are received by the two inputs before a dead zone of the switching power supply starts, so that the first transistor in a dead zone control circuit is turned on under a valid first enable signal to provide a pre-turn-on voltage for a source of the second transistor. When the first power transistor is switched off, the pre-turn-on voltage can quickly turn on the second transistor, so that a gate voltage of the second power transistor is the pre-turn-on voltage. In this way, the second power transistor is quickly turned on, to end the dead zone of the switching power supply, and implement dead zone control with zero dead time, so that the switching power supply can meet various requirements in high-frequency applications.

In a possible implementation of the second aspect, the second power transistor is an NMOS transistor. In this case, the first power transistor may be a PMOS transistor or an NMOS transistor. In the foregoing possible implementation, the second power transistor is an NMOS transistor. In this case, when the first power transistor is switched off, a gate voltage of the second power transistor is pulled up to the pre-turn-on voltage, a drain voltage of the second power transistor is a voltage of the first node, and the pre-turn-on voltage is greater than the voltage of the first node. In this way, the second power transistor is quickly turned on, to end the dead zone, and implement dead zone control with zero dead time.

In a possible implementation of the second aspect, the switching power supply further includes a weak pull-down circuit, configured to maintain a gate state of the second power transistor when the second enable signal is valid. The second enable signal is an inversion signal of the first enable signal. In the foregoing possible implementation, the weak pull-down circuit can improve stability when the second power transistor is turned on, thereby improving stability of the switching power supply.

In a possible implementation of the second aspect, the weak pull-down circuit includes a resistor and a third transistor. The third transistor may be an NMOS transistor. The resistor is coupled between a gate of the second power transistor and an electrode of the third transistor. Another electrode of the third transistor is coupled to the ground terminal. A gate of the third transistor is configured to receive the second enable signal. In the foregoing possible implementation, when the gate of the third transistor receives a valid second enable signal (assuming valid at a high level), a gate voltage of the third transistor is pulled up, and the third transistor is turned on, so that the gate of the second power transistor is connected to the ground terminal, and impedance of the gate of the second power transistor is equal to a sum of on impedance of the resistor and on impedance of the third transistor. That is, the impedance of the gate of the second power transistor is relatively large, so that when a gate current of the second power transistor is relatively small, a relatively large voltage may be provided for the gate of the second power transistor.

In a possible implementation of the second aspect, the logic processing circuit includes a delayer and a D flip-flop. An input of the delayer and a clock end of the D flip-flop are respectively used as two inputs of the logic processing circuit. An output of the delayer is coupled to a reset end of the D flip-flop. The input of the D flip-flop is set to a high level. An output of the D flip-flop is used as an output of the logic processing circuit.

In a possible implementation of the second aspect, the logic processing circuit includes a delayer, an AND gate, and three NOT gates. An input of the delayer and an input of a first NOT gate in the three NOT gates are respectively used as two inputs of the logic processing circuit. An output of the first NOT gate is coupled to an input of the AND gate. An output of the delayer is coupled to another input of the AND gate through a second NOT gate in the three NOT gates. An output of the AND gate is coupled to an input of a third NOT gate in the three NOT gates. An output of the third NOT gate is used as the output of the logic processing circuit.

In a possible implementation of the second aspect, the second drive circuit includes a NOT gate, a NOR gate, a first drive amplification circuit, and a second drive amplification circuit. An input of the NOT gate is coupled to a first input of the NOT gate and is configured to receive the second pulse width modulation signal. An output of the NOT gate is coupled to an input of a first drive amplification circuit. A second input of the NOR gate is configured to receive the second enable signal. An output of the NOR gate is coupled to an input of the second drive amplification circuit. Both an output of the first drive amplification circuit and an output of the second drive amplification circuit are coupled to the gate of the second power transistor. In the foregoing possible implementation, when the second enable signal is invalid, the second drive circuit is turned on, so that the second drive circuit may normally drive the second power transistor based on the second pulse width modulation signal. When the second enable signal is valid, the second drive circuit is switched off, so that the second drive circuit cannot be configured to drive the second power transistor, thereby avoiding impact of the second drive circuit on a gate state when the second power transistor is turned on.

In a possible implementation of the second aspect, the second power transistor is a PMOS transistor. In this case, the first power transistor may be an NMOS transistor. In the foregoing possible implementation, the second power transistor is a PMOS transistor. When the first power transistor is switched off, the gate voltage of the second power transistor is pulled down to the pre-turn-on voltage (that is, the ground terminal), the drain voltage of the second power transistor is the voltage of the first node, and the pre-turn-on voltage is less than the voltage of the first node. In this way, the second power transistor is quickly turned on, to end the dead zone, and implement dead zone control with zero dead time.

In a possible implementation of the second aspect, the switching power supply further includes a weak pull-up circuit, configured to maintain a gate state of the second power transistor when the second enable signal is valid. The second enable signal is an inversion signal of the first enable signal. In the foregoing possible implementation, the weak pull-up circuit can improve stability when the second power transistor is turned on, thereby improving stability of the switching power supply.

In a possible implementation of the second aspect, the weak pull-up circuit includes a resistor and a third transistor. The resistor is coupled between a gate of the second power transistor and an electrode of the third transistor. Another electrode of the third transistor is coupled to the first voltage terminal. The gate of the third transistor is configured to receive the second enable signal. In the foregoing possible implementation, when the gate of the third transistor receives the valid second enable signal, the gate voltage of the third transistor is pulled down, and the third transistor is switched off, so that the gate of the second power transistor is connected to the first voltage terminal, and impedance of the gate of the second power transistor is equal to a sum of on impedance of the resistor and on impedance of the third transistor. That is, the impedance of the gate of the second power transistor is relatively large, so that when the gate current of the second power transistor is relatively small, a relatively large voltage may be provided for the gate of the second power transistor.

In a possible implementation of the second aspect, the logic processing circuit includes two NOT gates, a delayer, and a D flip-flop. An input of a first NOT gate and an input of a second NOT gate in the two NOT gates are respectively used as two inputs of the logic processing circuit. An output of the first NOT gate is coupled to a reset end of the D flip-flop through the delayer. An input of the D flip-flop is set to a high level. An output of the second NOT gate is coupled to a clock end of the D flip-flop. An output of the D flip-flop is used as an output of the logic processing circuit.

In a possible implementation of the second aspect, the logic processing circuit includes a delayer, an AND gate, and a NOT gate. An input of the delayer and an input of the AND gate are respectively used as two inputs of the logic processing circuit. An output of the delayer is coupled to another input of the AND gate. An output of the AND gate is coupled to an input of the NOT gate. An output of the NOT gate is used as an output of the logic processing circuit.

In a possible implementation of the second aspect, the second drive circuit includes a NOT gate, a NAND gate, a first drive amplification circuit, and a second drive amplification circuit. An input of the NOT gate is coupled to a first input of the NOT gate and is configured to receive a second pulse width modulation signal. An output of the NOT gate is coupled to an input of a first drive amplification circuit. A second input of the NAND gate is configured to receive the second enable signal. An output of the NAND gate is coupled to an input of a second drive amplification circuit. Both an output of the first drive amplification circuit and an output of the second drive amplification circuit are coupled to the gate of the second power transistor. In the foregoing possible implementation, when the second enable signal is invalid, the second drive circuit is turned on, so that the second drive circuit may normally drive the second power transistor based on the second pulse width modulation signal. When the second enable signal is valid, the second drive circuit is switched off, so that the second drive circuit cannot be configured to drive the second power transistor, thereby avoiding impact of the second drive circuit on a gate state when the second power transistor is turned on.

In a possible implementation of the second aspect, the switching power supply further includes a power output path. The power output path includes an inductor and a capacitor that are serially coupled between the first node and the ground terminal.

According to a third aspect, a chip is provided. The chip is a power supply chip. The power supply chip includes the switching power supply according to any one of the first aspect, the possible implementations of the first aspect, the second aspect, or the possible implementations of the second aspect.

According to a fourth aspect, a chipset is provided. The chipset includes a system on chip SoC and a power supply chip that supplies power to the SoC. The power supply chip includes the switching power supply according to any one of the first aspect, the possible implementations of the first aspect, the second aspect, or the possible implementations of the second aspect.

According to a fifth aspect, an electronic device is provided. The electronic device includes a circuit board. The circuit board includes a system on chip SoC and a power supply chip that supplies power to the SoC. The power supply chip includes the switching power supply according to any one of the first aspect, the possible implementations of the first aspect, the second aspect, or the possible implementations of the second aspect.

It may be understood that the chip, the chipset, the electronic device, and the like according to any one of the foregoing aspects all include functions of the corresponding switching power supply provided above. Therefore, for beneficial effects that can be achieved, refer to beneficial effects of the corresponding switching power supply provided above. Details are not described herein again.

### BRIEF DESCRIPTION OF DRAWINGS

FIG. 1 is a schematic diagram of a structure of a switching power supply according to the conventional technology;
FIG. 2 is a schematic diagram of a structure of an electronic device according to an embodiment of this application;
FIG. 3 is a schematic diagram of a structure of a switching power supply according to an embodiment of this application;
FIG. 4 is a schematic diagram of a structure of another switching power supply according to an embodiment of this application;
FIG. 5 is a schematic diagram of a structure of another switching power supply according to an embodiment of this application;
FIG. 6 is a schematic diagram of a structure of another switching power supply according to an embodiment of this application;
FIG. 7 is a schematic diagram of a structure of a first drive circuit according to an embodiment of this application;
FIG. 8 is a schematic diagram of a structure of a logic processing circuit according to an embodiment of this application;
FIG. 9 is a sequence diagram of a switching power supply according to an embodiment of this application;
FIG. 10 is a schematic diagram of a structure of another switching power supply according to an embodiment of this application; and
FIG. 11 is a schematic diagram of a structure of another logic processing circuit according to an embodiment of this application.

### DESCRIPTION OF EMBODIMENTS

In this application, "at least one" means one or more, and "a plurality of" means two or more. "And/or" describes an association relationship between associated objects, and represents that three relationships may exist. For example, A and/or B may represent the following cases: only A exists, both A and B exist, and only B exists, where A and B may be singular or plural. "At least one of the following items (pieces)" or a similar expression thereof indicates any combination of these items, including a single item (piece) or any combination of a plurality of items (pieces). For example, at least one of a, b, or c may represent: a, b, c, a and b, a and c, b and c, or a, b, and c, where a, b, and c may be singular or plural.

In embodiments of this application, words such as "first" and "second" are used to distinguish objects with similar names or functions or effects. A person skilled in the art may understand that the words such as "first" and "second" do not limit a quantity and an execution sequence. The term "coupling" is used to represent an electrical connection, including direct connection via a wire or a connection end or indirect connection via another device. Therefore, "coupling" should be considered as a generalized electronic communication connection.

In embodiments of this application, both a transistor and a power transistor may refer to a metal oxide semiconductor (metal oxide semiconductor, MOS). Types of the transistor and the power transistor may include an N-type metal oxide semiconductor (N-type metal oxide semiconductor, NMOS) transistor and a P-type metal oxide semiconductor (P-type metal oxide semiconductor, PMOS) transistor. A difference between the transistor and the power transistor is that the power transistor is a MOS transistor with a relatively small on impedance (or a relatively large size). For example, the power transistor may be a MOS transistor with an on impedance greater than a milliohm (mΩ) level. In addition, two transistors (or power transistors) that are serially coupled in this specification may mean that a source of a first transistor in the two transistors is connected to a drain of a second transistor, and both a drain of the first transistor and a source of the second transistor are connected to an external circuit.

The technical solutions according to embodiments of this application may be applied to various electronic devices including a switching power supply, and the switching power supply may be a high-frequency switching power supply. The electronic device may include, but is not limited to, a personal computer, a server computer, a handheld or laptop device, a mobile device (such as a cell phone, a mobile phone, a tablet computer, a personal digital assistant, or a media player), a wearable device, an in-vehicle device, a consumer electronic device, a small computer, a mainframe computer, a mobile robot, an uncrewed aerial vehicle, and the like. The following describes a specific structure of the electronic device.

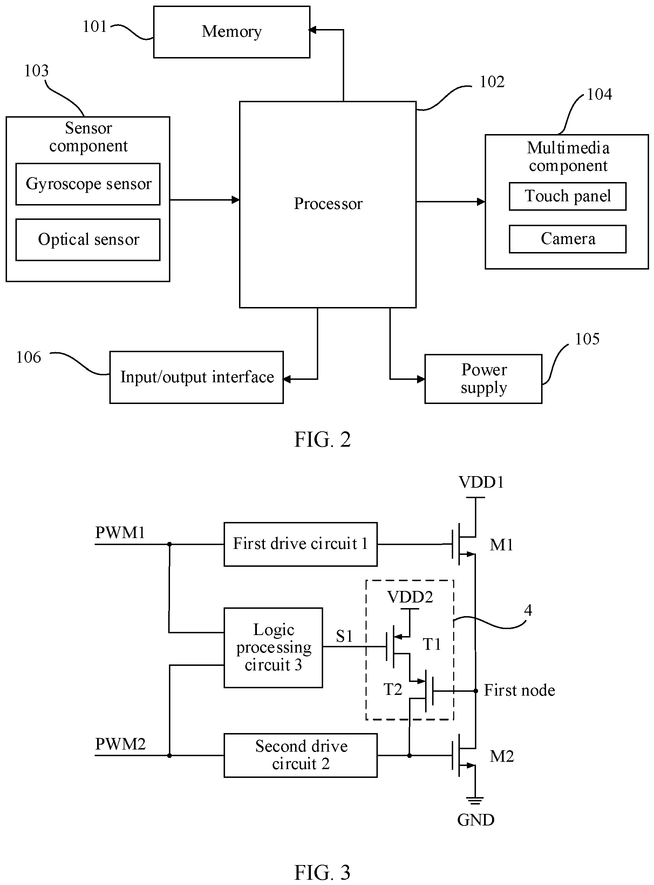

FIG. 2 is a schematic diagram of a structure of an electronic device according to an embodiment of this application. An example in which the electronic device is a mobile phone is used for description. As shown in FIG. 2, the electronic device may include a memory 101, a processor 102, a sensor component 103, a multimedia component 104, a power supply 105, and an input/output interface 106.

The memory 101 may be configured to store data, a software program, and a software module, and mainly includes a program storage area and a data storage area. The program storage area may store an operating system and an application program required by at least one function, such as a sound playing function or an image playing function. The data storage area may store data created based on use of the electronic device, such as audio data, image data, or a phone book. In addition, the electronic device may include a high-speed random access memory, and may further include a nonvolatile memory, for example, at least one magnetic disk storage device, a flash memory, or another volatile solid-state storage device.

The processor 102 is a control center of the electronic device, is connected to all parts of the entire device through various interfaces and lines, and performs various functions of the electronic device and data processing by running or executing a software program and/or a software module stored in the memory 101 and invoking data stored in the memory 101, to perform overall monitoring on the electronic device. Optionally, the processor 102 may include one or more processing units. For example, the processor 102 may include a central processing unit (central processing unit, CPU), an application processor (application processor, AP), a modem processor, a graphics processing unit (graphics processing unit, GPU), an image signal processor (image signal processor, ISP), a controller, a video codec, a digital signal processor (digital signal processor, DSP), a baseband processor, and/or a neural-network processing unit (neural-network processing unit, NPU). Different processing units may be independent devices, or may be integrated into one or more processors.

The sensor component 103 includes one or more sensors, configured to provide status evaluation in various aspects for the electronic device. The sensor component 103 may include an acceleration sensor, a gyroscope sensor, a magnetic sensor, a pressure sensor, or a temperature sensor. The sensor component 103 may detect acceleration/deceleration, an orientation, and an on/off state of the electronic device, relative positioning of a component, a temperature change of the electronic device, or the like. In addition, the sensor component 103 may further include an optical sensor, for example, a complementary metal oxide semiconductor (complementary metal oxide semiconductor, CMOS) or a charge-coupled device (charge-coupled device, CCD) image sensor, configured to be used in an imaging application, that is, become a component of a camera.

The multimedia component 104 is provided with a screen as an output interface allowing for interaction between the electronic device and a user. The screen may be a touch panel. When the screen is the touch panel, the screen may be implemented as a touchscreen, to receive an input signal from the user. The touch panel includes one or more touch sensors to sense touching, sliding, and a gesture on the touch panel. The touch sensor may not only sense a boundary of a touch action or a slide action, but also detect duration and a pressure related to the touch operation or the slide operation. In addition, the multimedia component 104 further includes at least one camera. For example, the multimedia component 104 includes a front-facing camera and/or a rear-facing camera. When the electronic device is in an operation mode, for example, a shooting mode or a video mode, the front-facing camera and/or the rear-facing camera may receive external multimedia data. Each front-facing camera or rear-facing camera may be a fixed optical lens system or has a focal length and an optical zoom capability.

The power supply 105 is configured to supply power to each component of the electronic device. The power supply 105 may include a power management system, one or more power supplies, or another component related to power generation, management, and distribution of the electronic device. In this embodiment of this application, the power supply 105 may include a power supply chip, and the power supply chip may include the switching power supply according to this specification.

The input/output interface 106 provides an interface between the processor 102 and a peripheral interface module. For example, the peripheral interface module may be a keyboard, a mouse, or a universal serial bus (universal serial bus, USB) device, or the like.

Although not shown, the electronic device may further include an audio component, a communication component, and the like. For example, the audio component includes a microphone, and the communication component includes a wireless fidelity (wireless fidelity, Wi-Fi) module, a Bluetooth module, or the like. Details are not described herein in this embodiment of this application. A person skilled in the art may understand that a structure of the electronic device shown in FIG. 2 constitutes no limitation on the electronic device. The electronic device may include more or fewer components than those shown in the figure, or have a combination of some components, or have a different component arrangement.

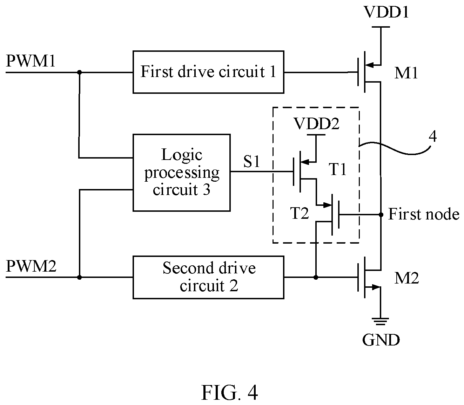

FIG. 3 and FIG. 4 are schematic diagrams of a structure of a switching power supply according to an embodiment of this application. The switching power supply includes a first power transistor M1, a second power transistor M2, a first drive circuit 1, a second drive circuit 2, a logic processing circuit 3, and a dead zone control circuit 4.

The first power transistor M1 and the second power transistor M2 are serially connected between a first voltage terminal VDD1 and a ground terminal GND. The first power transistor M1 and the second power transistor M2 are coupled to a first node. For example, the first power transistor M1 is coupled between the first voltage terminal VDD1 and the first node. The second power transistor M2 is coupled between the first node and the ground terminal GND. Optionally, as shown in FIG. 3, both the first power transistor M1 and the second power transistor M2 may be NMOS transistors, a drain of the first power transistor M1 is coupled to the first voltage terminal VDD 1, a source of the first power transistor M1 is coupled to a drain of the second power transistor M2, and a source of the second power transistor M2 is coupled to the ground terminal GND. Alternatively, as shown in FIG. 4, a first power transistor M1 is a PMOS transistor, a second power transistor M2 is an NMOS transistor, a source of the first power transistor M1 is coupled to the first voltage terminal VDD1, a drain of the first power transistor M1 is coupled to a drain of the second power transistor M2, and a source of the second power transistor M2 is coupled to the ground terminal GND.

The first drive circuit 1 is configured to drive the first power transistor M1 based on a first pulse width modulation signal PWM1. The second drive circuit 2 is configured to drive the second power transistor M2 based on a second pulse width modulation signal PWM2. For example, the first power transistor M1 and the second power transistor M2 shown in FIG. 3 are used as an example. The first drive circuit 1 may turn on the first power transistor M1 when the first pulse width modulation signal PWM1 is at a high level, and switch off the first power transistor M1 when the first pulse width modulation signal PWM1 is at a low level. The second drive circuit 2 may turn on the second power transistor M2 when the second pulse width modulation signal PWM2 is at a high level, and switch off the second power transistor M2 when the second pulse width modulation signal PWM2 is at a low level. When the first power transistor M1 and the second power transistor M2 are switched off at the same time, a dead zone of the switching power supply starts. When one of the first power transistor M1 and the second power transistor M2 is turned on, the dead zone of the switching power supply ends. A dead time is equal to a time when the first power transistor M1 and the second power transistor M2 are both in the turn-off state.

The logic processing circuit 3 is configured to output a first enable signal S1 based on the first pulse width modulation signal PWM1 and the second pulse width modulation signal PWM2. The first pulse width modulation signal PWM1 and the second pulse width modulation signal PWM2 are respectively configured to turn on or off the first power transistor M1 and the second power transistor M2, so that the logic processing circuit 3 may output a valid first enable signal S1 based on the first pulse width modulation signal PWM1 and the second pulse width modulation signal PWM2 before the dead zone of the switching power supply starts.

The dead zone control circuit 4 is configured to receive the first enable signal S1 and a pre-turn-on voltage and output the pre-turn-on voltage when the first enable signal S1 is valid and the first power transistor M1 is switched off. The pre-turn-on voltage may be configured to turn on the second power transistor M2. For example, as shown in FIG. 3 or FIG. 4, the dead zone control circuit 4 includes a first transistor T1 and a second transistor T2. The first transistor T1 and the second transistor T2 may be serially coupled between gates of a second voltage terminal VDD2 (that is, the pre-turn-on voltage) and the second power transistor M2. A gate of the first transistor T1 is configured to receive the first enable signal S1. A gate of the second transistor T2 is coupled to the first node.

Optionally, both the first transistor T1 and the second transistor T2 are PMOS transistors. A source of the first transistor T1 is coupled to the second voltage terminal VDD2, a drain of the first transistor T1 is coupled to a source of the second transistor T2, and a drain of the second transistor T2 is coupled to the gate of the second power transistor M2. Specifically, when the gate of the first transistor T1 receives a valid first enable signal S1 (valid at a low level), a gate voltage of the first transistor T1 is pulled down, so that the first transistor T1 is turned on. Because the drain of the first transistor T1 is coupled to the source of the second transistor T2, the source of the second transistor T2 is pulled up to the pre-turn-on voltage, and the pre-turn-on voltage may be equal to the second voltage terminal VDD2. When the first power transistor M1 is switched off so that a voltage V1 of the first node is less than a first preset voltage, the pre-turn-on voltage may quickly turn on the second transistor T2. For example, the first preset voltage may be 0.3 V, 0.4 V, or the like. Because the drain of the second transistor T2 is coupled to the gate of the second power transistor M2, a gate voltage of the second power transistor M2 is quickly pulled up, so that the second power transistor M2 is turned on.

In the switching power supply according to this embodiment of this application, in a process in which the first drive circuit 1 and the second drive circuit 2 respectively drive, through the first pulse width modulation signal PWM1 and the second pulse width modulation signal PWM2, the first power transistor M1 and the second power transistor M2 to perform voltage conversion, the logic processing circuit 3 may output a valid first enable signal S1 based on the first pulse width modulation signal PWM1 and the second pulse width modulation signal PWM2 before the dead zone of the switching power supply starts, so that the dead zone control circuit 4 is turned on under the valid first enable signal S1 to provide a pre-turn-on voltage. In this way, when the first power transistor M1 is switched off so that a voltage of the first node to which the first power transistor M1 and the second power transistor M2 are coupled is less than the first preset voltage, the pre-turn-on voltage can quickly turn on the second power transistor M2, to end the dead zone, and implement dead zone control with zero dead time, so that the switching power supply can meet various requirements in high-frequency applications.

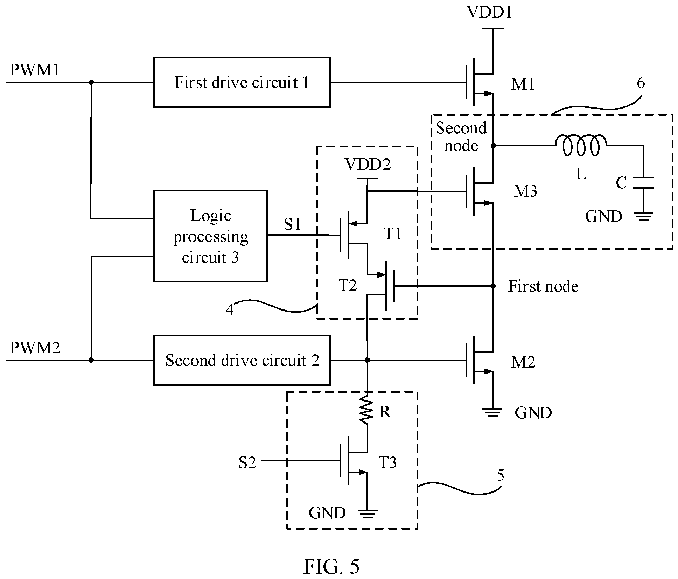

Further, as shown in FIG. 5, the switching power supply further includes a weak pull-down circuit 5, configured to maintain a gate state of the second power transistor M2 when the second enable signal S2 is valid, or configured to provide impedance for the gate of the second power transistor M2 when the second enable signal S2 is valid. Herein, maintaining the gate state of the second power transistor M2 and providing impedance for the gate of the second power transistor M2 may be both understood as maintaining the gate of the second power transistor M2 in a closed state (or referred to as a grounded state). The second enable signal S2 is an inversion signal of the first enable signal S1. That is, when the first enable signal S1 is at a high level, the second enable signal S2 is at a low level; and when the first enable signal S1 is at a low level, the second enable signal S2 is at a high level. In addition, the second enable signal S2 may be valid at a high level and invalid at a low level.

For example, the weak pull-down circuit 5 includes a resistor R and a third transistor T3. For example, the third transistor T3 is an NMOS transistor. The third transistor T3 is coupled between one end of the resistor R and the ground terminal GND, a gate of the third transistor T3 is used as an input of the weak pull-down circuit 5, and another end of the resistor R is used as an output of the weak pull-down circuit 5. Specifically, when the gate of the third transistor T3 receives a valid second enable signal S2 (valid at a high level), a gate voltage of the third transistor T3 is pulled up, and the third transistor T3 is turned on, so that the gate of the second power transistor M2 is connected to the ground terminal GND, and impedance of the gate of the second power transistor M2 is equal to a sum of on impedance of the resistor R and on impedance of the third transistor T3. That is, impedance of the gate of the second power transistor M2 is relatively large, so that when a gate current of the second power transistor M2 is relatively small, a relatively large voltage may be provided for the gate of the second power transistor M2.

It should be noted that the weak pull-down circuit 5 may alternatively be another circuit structure having a same function. For example, the weak pull-down circuit 5 may include only a third transistor T3 with relatively large on impedance. For example, the on impedance may be at a kiloohm level to a megaohm level. The weak pull-down circuit 5 shown in FIG. 5 is merely an example, and does not constitute a limitation on this embodiment of this application.

In a possible embodiment, as shown in FIG. 5, the switching power supply may further include a power output path 6. The power output path 6 includes a third power transistor M3, an inductor L, and a capacitor C. The third power transistor M3 may be an NMOS transistor. The third power transistor M3 is coupled between the first power transistor M1 and the second power transistor M2. A coupling point between the third power transistor M3 and the second power transistor M2 is a first node. A coupling point between the third power transistor M3 and the first power transistor M1 is a second node. The inductor L and the capacitor C are serially coupled between the second node and a ground terminal GND. A gate of the third power transistor M3 may be coupled to a second voltage terminal VDD2. The second voltage terminal VDD2 is not equal to a first voltage terminal VDD 1. Optionally, the power output path 6 may alternatively include only the inductor L and the capacitor C, and the inductor L and the capacitor C are serially coupled between the first node and the ground terminal. When the power output path 6 does not include the third power transistor M3, the first power transistor M1 independently bears the first voltage terminal VDD1; and when the power output path 6 includes the third power transistor M3, the first power transistor M1 and the third power transistor M3 jointly bear the first voltage terminal VDD1, so that a voltage withstand capability of the power transistor in the switching power supply can be improved compared with a case in which the power output path 6 does not include the third power transistor M3.

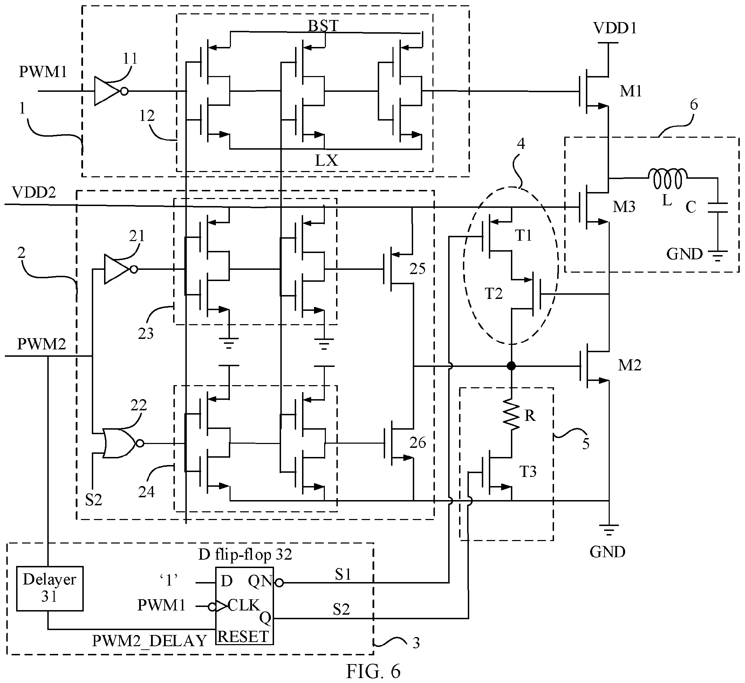

Further, as shown in FIG. 6, the first drive circuit 1 in the switching power supply may include a NOT gate (which may also be referred to as an inverter) 11 and a plurality of serially connected transistor sets 12 coupled to an output of the NOT gate 11. Each transistor set includes two transistors coupled in parallel. An input of the NOT gate 11 is used as an input of the first drive circuit 1. An output of the last transistor set in the plurality of serially connected transistor sets 12 is used as an output of the first drive circuit 1. For example, each transistor set includes one PMOS transistor and one NMOS transistor. A source of the PMOS transistor is coupled to a third voltage terminal BST. A source of the NMOS transistor is coupled to a fourth voltage terminal LX. A gate of the PMOS transistor and a gate of the NMOS transistor are coupled as an input of the transistor set. A drain of the PMOS transistor and a drain of the NMOS transistor are coupled as an output of the transistor set. In FIG. 6, three serially connected transistor sets are used as an example for description.

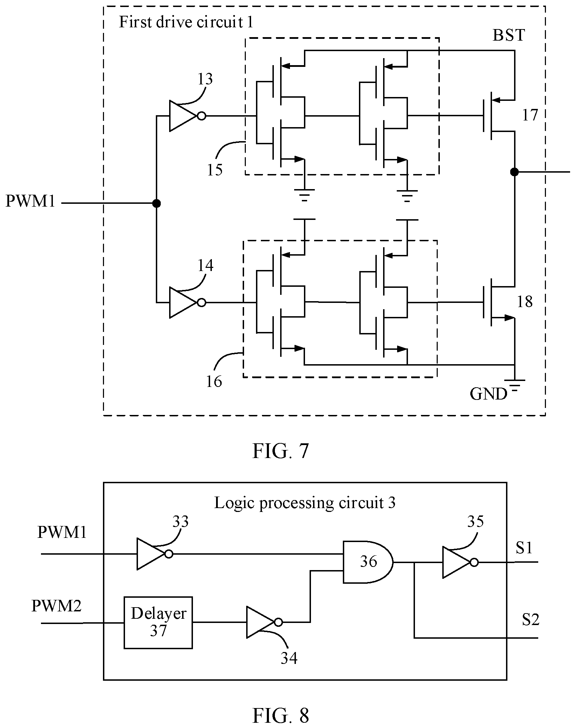

Alternatively, as shown in FIG. 7, the first drive circuit 1 may include: two NOT gates 13 and 14, a plurality of serially connected transistor sets 15 (or 16) coupled to an output of each NOT gate 13 (or 14), and two transistors 17 and 18 serially connected between a third voltage terminal BST and a fourth voltage terminal LX. Inputs of the two NOT gates 13 and 14 are coupled to each other and used as an input of the first drive circuit 1. A coupling point between the two transistors 17 and 18 is used as an output of the first drive circuit 1. Outputs of the last transistor set in the serially connected transistor set 15 or 16 corresponding to the two NOT gates 13 and 14 is separately coupled to gates of the two transistors 17 and 18. A connection manner of each transistor set is consistent with a connection manner in FIG. 6. In FIG. 7, an example in which each NOT gate 13 (or 14) in the first drive circuit 1 is coupled to two serially connected transistor sets 15 (or 16), and the two transistors 17 and 18 are a PMOS transistor and an NMOS transistor respectively is used for description.

Further, as shown in FIG. 6, the second drive circuit 2 in the switching power supply may include: one NOT gate 21, one NOR gate 22, a plurality of serially connected transistor sets 23 coupled to an output of the NOT gate 21, a plurality of serially connected transistor sets 24 coupled to an output of the NOR gate 22, and two transistors 25 and 26 serially connected between the second voltage terminal VDD2 and the ground terminal GND. An input of the NOT gate 21 is coupled to one input of the NOR gate 22 and is configured to receive a second pulse width modulation signal PWM2. Another input of the NOR gate 22 is configured to receive a second enable signal S2. A coupling point between the two transistors 25 and 26 is used as an output of the second drive circuit 2. Outputs of the last transistor set corresponding to the NOT gate 21 and the NOR gate 22 are respectively coupled to gates of the two transistors 25 and 26. In FIG. 6, an example in which a plurality of serially connected transistor sets 23 or 24 in the second drive circuit 2 include two serially connected transistor sets, and the two transistors 25 and 26 are a PMOS transistor and an NMOS transistor respectively is used for description. Specifically, when the second enable signal S2 is at a low level (that is, invalid), the weak pull-down circuit 5 is switched off, the second drive circuit 2 is turned on, and the second drive circuit 2 may normally drive the second power transistor M2 based on the second pulse width modulation signal PWM2. When the second enable signal S2 is at a high level (that is, valid), the second drive circuit 2 is switched off, the weak pull-down circuit 5 is turned on, the second drive circuit 2 cannot be configured to drive the second power transistor M2, and the weak pull-down circuit 5 is configured to provide impedance for a gate of the second power transistor M2, to maintain a gate state of the second power transistor M2.

The plurality of serially connected transistor sets 23 (or 24) and the transistor 25 (or 26) coupled to outputs of the transistor sets 23 (or 24) may be collectively referred to as a drive amplification circuit. For example, the plurality of serially connected transistor sets 23 coupled to the output of the NOT gate 21 and the PMOS transistor (that is, the transistor 25) coupled to the outputs of the transistor sets 23 may be referred to as a first drive amplification circuit. The plurality of serially connected transistor sets 24 coupled to the output of the NOR gate 22 and an NMOS transistor (that is, a transistor 26) coupled to the outputs of the transistor sets 24 may be referred to as a second drive amplification circuit.

It should be noted that, when the power output path 6 of the switching power supply does not include the third power transistor M3, the foregoing second voltage terminal VDD2 and the third voltage terminal BST may be the same as or different from the first voltage terminal VDD1, and the fourth voltage terminal LX may be the same as or different from the ground terminal GND.

Further, as shown in FIG. 6, the logic processing circuit 3 in the switching power supply may include a delayer 31 and a D flip-flop 32. An input of the delayer 31 and a clock end CLK of the D flip-flop 32 are respectively used as two inputs of the logic processing circuit 3. For example, the input of the delayer 31 is configured to receive a second pulse width modulation signal PWM2, and the clock end CLK of the D flip-flop 32 is configured to receive a first pulse width modulation signal PWM1. An output of the delayer 31 is coupled to a reset end RESET of the D flip-flop 32, and an input (represented as D) of the D flip-flop 32 is set to a high level (represented as "1"). Two outputs (represented as QN and Q) of the D flip-flop 32 are used as two outputs of the logic processing circuit 3. For example, the first output QN is configured to output a first enable signal S1, and the second output Q is configured to output a second enable signal S2.

Alternatively, as shown in FIG. 8, the logic processing circuit 3 includes three NOT gates (that is, 33, 34, and 35), one AND gate 36, and one delayer 37. An input of a first NOT gate 33 in the three NOT gates is configured to receive a first pulse width modulation signal PWM1, and an output of the first NOT gate 33 is coupled to an input of the AND gate 36. An input of the delayer 37 is configured to receive a second pulse width modulation signal PWM2. An output of the delayer 37 is coupled to an input of a second NOT gate 34 in the three NOT gates, and an output of the second NOT gate 34 is coupled to another input of the AND gate 36. An output of the AND gate 36 is coupled to an input of a third NOT gate 35 in the three NOT gates, and the output of the AND gate 36 is further configured to output the second enable signal S2. An output of the third NOT gate 35 is configured to output the first enable signal S1.

For example, when a high-level first pulse width modulation signal PWM1 is used to turn on the first power transistor M1, a low-level first pulse width modulation signal PWM1 is used to switch off the first power transistor M1, a low-level second pulse width modulation signal PWM2 is used to switch off the second power transistor M2, and a high-level second pulse width modulation signal PWM2 is used to turn on the second power transistor M2, the foregoing logic processing circuit 3 may output a valid first enable signal S1 and a valid second enable signal S2 between a falling edge of the first pulse width modulation signal PWM1 and a rising edge of a delay signal PWM2_DELAY of the second pulse width modulation signal PWM2. For example, the first enable signal S 1 is valid at a low level, and the second enable signal S2 is valid at a high level.

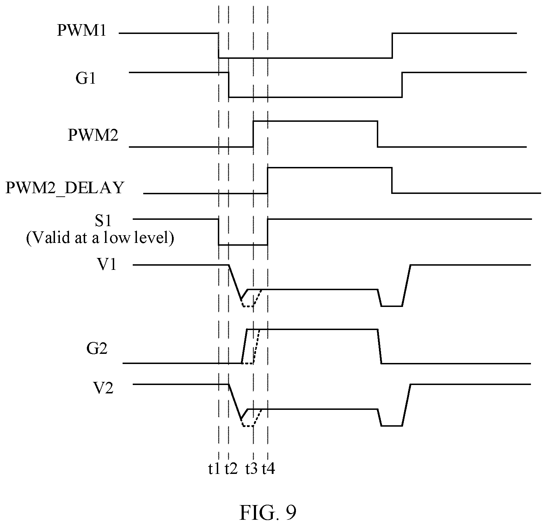

Specifically, in a working process of the switching power supply, as shown in FIG. 9, when a falling edge of the first pulse width modulation signal PWM1 arrives at a moment 11, the logic processing circuit 3 outputs a low-level first enable signal S1 (valid at a low level), and the dead zone control circuit 4 is turned on under the low-level first enable signal S1 to provide a pre-turn-on voltage. Afterward, when the first power transistor M1 is switched off at a moment t2 (that is, a gate voltage G1 of the first power transistor M1 is flipped from a high level to a low level), the voltage V1 of the first node starts to decrease. When the voltage V1 of the first node is less than the first preset voltage, the pre-turn-on voltage may quickly turn on the second power transistor (that is, a gate voltage G2 of the second power transistor M2 is pulled up from a low level to a high level). At a moment t3, a rising edge of the second pulse width modulation signal PWM2 arrives, and at a moment t4, a rising edge of the delay signal PWM2_DELAY of the second pulse width modulation signal arrives, so that the first enable signal S 1 is flipped from a low voltage (valid) to a high voltage (invalid). V2 in FIG. 9 represents a voltage of the second node when the power output path 6 includes the third power transistor M3, and a change rule of the voltage V2 of the second node is consistent with a change rule of the voltage V1 of the first node. In FIG. 9, solid lines in the voltage V1 of the first node, the gate voltage G2 of the second power transistor M2, and the voltage V2 of the second node indicate voltage changes when the solution of this application is used, and dashed lines indicate voltage changes when the solution of this application is not used. It can be learned that, when the solution of this application is not used, the gate voltage G2 of the second power transistor M2 can be flipped from a low level to a high level only after the moment t3 (in other words, the second power transistor M2 is turned on after the moment t3). In the solution of this application, before the moment t3, the gate voltage of the second power transistor may be flipped from a low level to a high level (in other words, the second power transistor M2 is turned on before the moment t3).

It should be noted that, an example in which related structures and working principles of the foregoing weak pull-down circuit 5, the power output path 6, the first drive circuit 1, the second drive circuit 2, and the logic processing circuit 3 described in FIG. 5 to FIG. 9 are all based on the switching power supply shown in FIG. 3 is used for description. The foregoing structures are also applicable to the switching power supply shown in FIG. 4. Details are not described herein again in this embodiment of this application.

It should be noted that, in FIG. 3 to FIG. 9, an example in which the first power transistor M1 is coupled between the first voltage terminal VDD 1 and the first node, and the second power transistor M2 is coupled between the first node and the ground terminal GND (referred to as a first coupling manner below) is used for description. In another implementation, the first power transistor M1 may alternatively be coupled between the first node and the ground terminal GND, and the second power transistor M2 is coupled between the first voltage terminal VDD and the first node (referred to as a second coupling manner below). When the first power transistor M1 and the second power transistor M2 are coupled in the second coupling manner, a specific structure of the switching power supply is different, and details are described below.

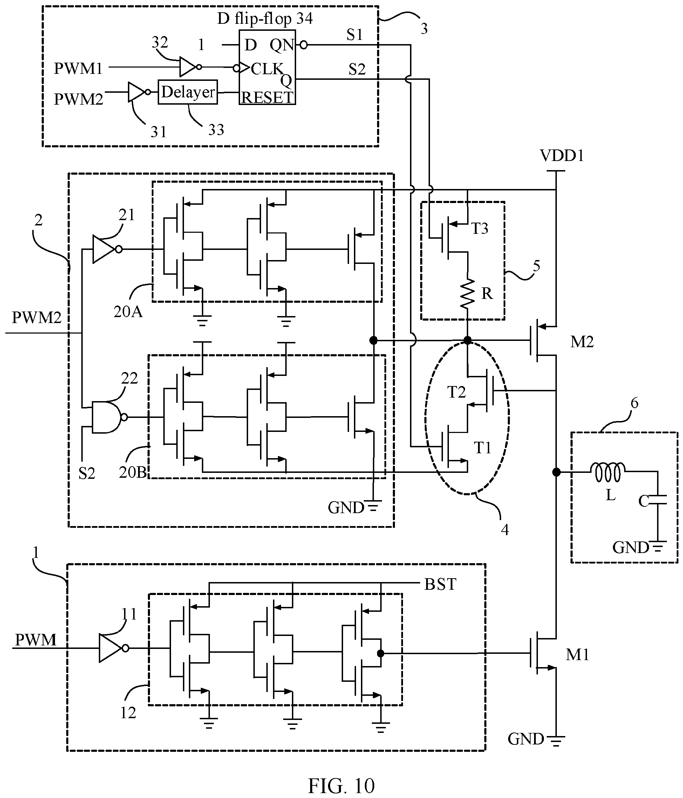

FIG. 10 is a schematic diagram of a structure of another switching power supply according to an embodiment of this application. The switching power supply includes a first power transistor M1, a second power transistor M2, a first drive circuit 1, a second drive circuit 2, a logic processing circuit 3, and a dead zone control circuit 4. The first power transistor M1 and the second power transistor M2 herein are coupled in the foregoing second coupling manner. In FIG. 10, an example in which the first power transistor M1 is an NMOS transistor and the second power transistor M2 is a PMOS transistor is used for description.

Specifically, the first drive circuit 1 is configured to drive the first power transistor M1 based on a first pulse width modulation signal PWM1. The second drive circuit 2 is configured to drive the second power transistor M2 based on a second pulse width modulation signal PWM2. The logic processing circuit 3 is configured to output a first enable signal S1 based on the first pulse width modulation signal PWM1 and the second pulse width modulation signal PWM2. The dead zone control circuit 4 is configured to receive the first enable signal S1, turn on when the first enable signal S1 is valid to provide a pre-turn-on voltage, and output the pre-turn-on voltage when the first power transistor M1 is switched off. The pre-turn-on voltage is used to turn on the second power transistor M2.

The second drive circuit 2 includes a NOT gate 21, a NAND gate 22, a first drive amplification circuit 20A, and a second drive amplification circuit 20B. An input of the NOT gate 21 is coupled to a first input of the NAND gate 22 and is configured to receive a second pulse width modulation signal PWM2. An output of the NOT gate 21 is coupled to an input of the first drive amplification circuit 20A. A second input of the NAND gate 22 is configured to receive a second enable signal S2. An output of the NAND gate 22 is coupled to an input of the second drive amplification circuit 20B. An output of the first drive amplification circuit 20A and an output of the second drive amplification circuit 20B are both coupled to a gate of the second power transistor M2. The first drive amplification circuit 20A and the second drive amplification circuit 20B are respectively consistent with the first drive amplification circuit (that is, including 21, 23, and 25) and the second drive amplification circuit (that is, including 22, 24, and 26) described in FIG. 6. Details are not described herein again in this embodiment of this application.

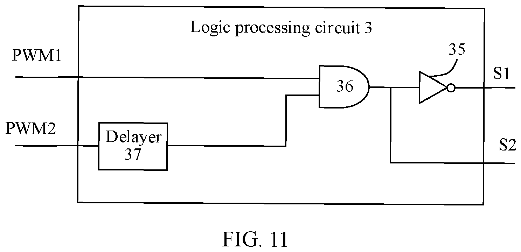

In addition, the logic processing circuit 3 may include two NOT gates 31 and 32, a delayer 33, and a D flip-flop 34. An input of a first NOT gate 31 and an input of a second NOT gate 32 in the two NOT gates are respectively used as two inputs of the logic processing circuit 3. For example, the input of the first NOT gate 31 is configured to receive the second pulse width modulation signal PWM2, and the input of the second NOT gate 32 is configured to receive the first pulse width modulation signal PWM1. An output of the first NOT gate 31 is coupled to a reset end RESET of the D flip-flop 34 through the delayer 33, and an input (represented as D) of the D flip-flop 34 is set to a high level (represented as "1"). An output of the second NOT gate 32 is coupled to a clock end CLK of the D flip-flop 34, and two outputs (represented as QN and Q) of the D flip-flop 34 are used as two outputs of the logic processing circuit 3. For example, a first output QN is configured to output the first enable signal S 1. A second output Q is configured to output the second enable signal S2. Alternatively, as shown in FIG. 11, the logic processing circuit 3 includes one NOT gate 35, one AND gate 36, and one delayer 37. An input of the delayer 37 and an input of the AND gate 36 are respectively used as two inputs of the logic processing circuit 3. For example, the input of the delayer 37 is configured to receive the second pulse width modulation signal PWM2, and an input of the AND gate 36 is configured to receive the first pulse width modulation signal PWM1. An output of the AND gate 36 is coupled to an input of the NOT gate 35. An output of the NOT gate 35 is used as an output of the logic processing circuit 3 and is configured to output the first enable signal S1. The output of the AND gate 36 is used as another output of the logic processing circuit 3 and is configured to output the second enable signal S2.

In addition, the dead zone control circuit 4 may include a first transistor T1 and a second transistor T2. The first transistor T1 and the second transistor T2 may be serially coupled between gates of a ground terminal GND and the second power transistor M2. A gate of the first transistor T1 is configured to receive the first enable signal S1, and a gate of the second transistor T2 is coupled to a first node. Optionally, both the first transistor T1 and the second transistor T2 are NMOS transistors. A source of the first transistor T1 is coupled to the ground terminal GND. A drain of the first transistor T1 is coupled to a source of the second transistor T2. A drain of the second transistor T2 is coupled to a gate of the second power transistor M2. Specifically, when the gate of the first transistor T1 receives a valid first enable signal S1 (valid at a high level), a gate voltage of the first transistor T1 is pulled up, so that the first transistor T1 is turned on. Because the drain of the first transistor T1 is coupled with the source of the second transistor T2, the source of the second transistor T2 is pulled down, that is, the provided pre-turn-on voltage is equal to a voltage of the ground terminal GND. When the first power transistor M1 is switched off so that a voltage V1 of the first node is greater than a second preset voltage, the second transistor T2 may be quickly turned on. For example, the second preset voltage may be 0.7 V, 0.8 V, or the like. Because the drain of the second transistor T2 is coupled to the gate of the second power transistor M2, a gate voltage of the second power transistor M2 is quickly pulled down, so that the second power transistor M2 is turned on.

Further, the switching power supply further includes a weak pull-up circuit 5, including a resistor R and a third transistor T3. For example, the third transistor T3 is a PMOS transistor. The third transistor T3 may be coupled between one end of the resistor R and a first voltage terminal VDD1. A gate of the third transistor T3 is used as an input of the weak pull-up circuit 5, and another end of the resistor R is used as an output of the weak pull-up circuit 5. Specifically, when the gate of the third transistor T3 receives a valid second enable signal S2 (valid at a low level), a gate voltage of the third transistor T3 is pulled down, and the third transistor T3 is turned on, so that the gate of the second power transistor M2 is connected to the first voltage terminal VDD 1, and impedance of the gate of the second power transistor M2 is equal to a sum of on impedance of the resistor R and on impedance of the third transistor T3. That is, impedance of the gate of the second power transistor M2 is relatively large, so that when a gate current of the second power transistor M2 is relatively small, a relatively large voltage may be provided for the gate of the second power transistor M2.

It should be noted that, the foregoing related description of the second coupling manner shows only a difference from that of the first coupling manner. Other related structures and principles of the switching power supply in the second coupling manner are similar to the foregoing related structures and principles in FIG. 3 to FIG. 9. For example, specific structures and working principles of the first drive circuit 1 and the power output path in the switching power supply, and the foregoing related descriptions of the second drive circuit 2, the logic processing circuit 3, and the dead zone control circuit 4 are all similar. For details, refer to the foregoing description. Details are not described herein again in this embodiment of this application.

In the switching power supply according to this embodiment of this application, in a process in which the first drive circuit 1 and the second drive circuit 2 respectively drive, through the first pulse width modulation signal PWM1 and the second pulse width modulation signal PWM2, the first power transistor M1 and the second power transistor M2 to perform voltage conversion, the logic processing circuit 3 may output a valid first enable signal S1 based on the first pulse width modulation signal PWM1 and the second pulse width modulation signal PWM2 before a dead zone of the switching power supply starts, so that the dead zone control circuit 4 is turned on under the valid first enable signal S 1 to provide a pre-turn-on voltage. In this way, when the first power transistor M1 is switched off so that a voltage of the first node to which the first power transistor M1 and the second power transistor M2 are coupled is greater than the second preset voltage, the pre-turn-on voltage can quickly turn on the second power transistor M2, to end the dead zone, and implement dead zone control of zero dead time, so that the switching power supply can meet various requirements in high-frequency applications.

In an actual application, all circuits in the switching power supply may be integrated into one chip; or other circuits in the switching power supply except an inductor L and a capacitor C in the power output channel 6 are integrated into one chip; or other circuits in the switching power supply except the power transistors (for example, the first power transistor M1, the second power transistor M2, and the third power transistor M3) and the inductor L and the capacitor C in the power output channel 6 are integrated into one chip. This is not specifically limited in this embodiment of this application.

Based on this, an embodiment of this application further provides a chipset. The chipset may include a plurality of chips in a terminal. Optionally, the chipset includes a system on chip (system on chip, SoC) and a power supply chip that supplies power to the SoC. The power supply chip may include any switching power supply provided above.

An embodiment of this application further provides an electronic device. The device includes a circuit board. The circuit board includes an SoC and a power supply chip that supplies power to the SoC. The power supply chip may include any switching power supply provided above.

It should be noted that all related descriptions of the switching power supply provided above can be applied to the chipset or the electronic device. Details are not described herein again in this embodiment of this application.

In conclusion, the foregoing descriptions are merely specific implementations of this application, but are not intended to limit the protection scope of this application. Any variation or replacement within the technical scope disclosed in this application shall fall within the protection scope of this application. Therefore, the protection scope of this application shall be subject to the protection scope of the claims.

## Claims

1. A switching power supply, comprising:
a first power transistor and a second power transistor, wherein the first power transistor and the second power transistor are serially connected between a first voltage terminal and a ground terminal, and the first power transistor and the second power transistor are coupled to a first node;
a first drive circuit, configured to drive the first power transistor based on a first pulse width modulation signal;
a second drive circuit, configured to drive the second power transistor based on a second pulse width modulation signal;
a logic processing circuit, configured to output a first enable signal based on the first pulse width modulation signal and the second pulse width modulation signal; and
a dead zone control circuit, configured to receive the first enable signal and a pre-turn-on voltage, and output the pre-turn-on voltage when the first enable signal is valid and the first power transistor is switched off, wherein the pre-turn-on voltage is used to turn on the second power transistor.

2. The switching power supply according to claim 1, wherein the second power transistor is an N-type metal oxide semiconductor NMOS transistor.

3. The switching power supply according to claim 2, wherein the dead zone control circuit comprises a first transistor and a second transistor; and
the first transistor and the second transistor are serially coupled between gates of a second voltage terminal and the second power transistor, a gate of the first transistor is configured to receive the first enable signal, and a gate of the second transistor is coupled to the first node.

4. The switching power supply according to claim 2 or 3, wherein the switching power supply further comprises a weak pull-down circuit, configured to maintain a gate state of the second power transistor when a second enable signal is valid, wherein the second enable signal is an inversion signal of the first enable signal.

5. The switching power supply according to claim 4, wherein the weak pull-down circuit comprises a resistor and a third transistor; and
the resistor is coupled between a gate of the second power transistor and an electrode of the third transistor, another electrode of the third transistor is coupled to the ground terminal, and a gate of the third transistor is configured to receive the second enable signal.

6. The switching power supply according to any one of claims 2 to 5, wherein the logic processing circuit comprises a delayer and a D flip-flop; and
an input of the delayer is configured to receive the second pulse width modulation signal, an output of the delayer is coupled to a reset end of the D flip-flop, an input of the D flip-flop is set to a high level, a clock end of the D flip-flop is configured to receive the first pulse width modulation signal, and an output of the D flip-flop is configured to output the first enable signal.

7. The switching power supply according to any one of claims 2 to 5, wherein the logic processing circuit comprises a delayer, an AND gate, and three NOT gates; and
an input of a first NOT gate in the three NOT gates is configured to receive the first pulse width modulation signal, an output of the first NOT gate is coupled to an input of the AND gate, an input of the delayer is configured to receive the second pulse width modulation signal, an output of the delayer is coupled to another input of the AND gate through a second NOT gate in the three NOT gates, an output of the AND gate is coupled to an input of a third NOT gate in the three NOT gates, and an output of the third NOT gate is configured to output the first enable signal.

8. The switching power supply according to any one of claims 2 to 7, wherein the second drive circuit comprises a NOT gate, a NOR gate, a first drive amplification circuit, and a second drive amplification circuit; and
an input of the NOT gate is coupled to a first input of the NOR gate and is configured to receive the second pulse width adjustment signal, an output of the NOT gate is coupled to an input of the first drive amplification circuit, a second input of the NOR gate is configured to receive the second enable signal, an output of the NOR gate is coupled to an input of the second drive amplification circuit, and an output of the first drive amplification circuit and an output of the second drive amplification circuit are both coupled to a gate of the second power transistor.

9. The switching power supply according to claim 1, wherein the second power transistor is a P-type metal oxide semiconductor PMOS transistor.

10. The switching power supply according to claim 9, wherein the dead zone control circuit comprises a first transistor and a second transistor; and
the first transistor and the second transistor are serially coupled between gates of the ground terminal and the second power transistor, a gate of the first transistor is configured to receive the first enable signal, and a gate of the second transistor is coupled to the first node.

11. The switching power supply according to claim 9 or 10, wherein the switching power supply further comprises
a weak pull-up circuit, configured to maintain a gate state of the second power transistor when a second enable signal is valid, wherein the second enable signal is an inversion signal of the first enable signal.

12. The switching power supply according to claim 11, wherein the weak pull-up circuit comprises a resistor and a third transistor; and
the resistor is coupled between a gate of the second power transistor and an electrode of the third transistor, another electrode of the third transistor is coupled to the first voltage terminal, and a gate of the third transistor is configured to receive the second enable signal.

13. The switching power supply according to any one of claims 9 to 12, wherein the logic processing circuit comprises two NOT gates, a delayer, and a D flip-flop; and
an input of a first NOT gate in the two NOT gates is configured to receive the second pulse width modulation signal, an output of the first NOT gate is coupled to a reset end of the D flip-flop through the delayer, an input of the D flip-flop is set to a high level, an input of a second NOT gate in the two NOT gates is configured to receive the first pulse width modulation signal, an output of the second NOT gate is coupled to a clock end of the D flip-flop, and an output of the D flip-flop is configured to output the first enable signal.

14. The switching power supply according to any one of claims 9 to 12, wherein the logic processing circuit comprises a delayer, an AND gate, and a NOT gate; and
an input of the AND gate is configured to receive the first pulse width modulation signal, an input of the delayer is configured to receive the second pulse width modulation signal, an output of the delayer is coupled to another input of the AND gate, an output of the AND gate is coupled to an input of the NOT gate, and an output of the NOT gate is configured to output the first enable signal.

15. The switching power supply according to any one of claims 9 to 14, wherein the second drive circuit comprises a NOT gate, a NAND gate, a first drive amplification circuit, and a second drive amplification circuit; and
the input of the NOT gate is coupled to a first input of the NAND gate and is configured to receive the second pulse width adjustment signal, the output of the NOT gate is coupled to an input of the first drive amplification circuit, a second input of the NAND gate is configured to receive the second enable signal, an output of the NAND gate is coupled to an input of the second drive amplification circuit, and an output of the first drive amplification circuit and an output of the second drive amplification circuit are both coupled to the gate of the second power transistor.

16. The switching power supply according to any one of claims 1 to 15, wherein the switching power supply further comprises a power output path, and the power output path comprises an inductor and a capacitor that are serially coupled between the first node and the ground terminal.

17. A chipset, wherein the chipset comprises a system on chip SoC and a power supply chip that supplies power to the SoC, and the power supply chip comprises the switching power supply according to any one of claims 1 to 16.

18. An electronic device, wherein the electronic device comprises a circuit board, the circuit board comprises a system on chip SoC and a power supply chip that supplies power to the SoC, and the power supply chip comprises the switching power supply according to any one of claims 1 to 16.
